# EUROPÄISCHE PATENTSCHRIFT

(11) **EP 0 615 310 B1**
(45) Veröffentlichungstag und Bekanntmachung des Hinweises auf die Patenterteilung: **24.06.1998**
(21) Anmeldenummer: 94103127.0
(22) Anmeldetag: 02.03.1994
(51) Int. Cl.: H01R 9/09, F16B 17/00, H05K 3/32

(54) **Einpress-Befestigung für Bauteile in Leiterplattenbohrungen**
Press fit connection for components in holes of a printed circuit board
Fixation en force pour composants dans les trous d'un circuit imprimé

(30) Priorität: 09.03.1993 DE 9303464 U
(43) Veröffentlichungstag der Anmeldung: 14.09.1994
(73) Patentinhaber: SIEMENS AKTIENGESELLSCHAFT, 80333 München (DE)
(72) Erfinder: Longueville, Jacques, B-8020 Oostkamp (BE)

(56) Entgegenhaltungen:
- EP-A- 0 140 615
- US-A- 3 725 853
- US-A- 3 731 252
- US-A- 4 691 971
- US-A- 4 759 721

## Beschreibung

Die Erfindung betrifft eine Einpreß-Befestigung für mit einem Anschlußstiel ausgebildete Bauteile in Leiterplattenbohrungen, wobei die Anschlußstiele der Bauteile eine im Querschnitt rechteckige Grundform aufweisen, insbesondere für Steckverbinder oder Teile davon.

Bei der Anordnung und Fixierung von Bauteilen oder Bauelementen an Leiterplatten ist die Einpreß-Befestigung mittlerweile eine übliche Verbindungstechnik, mit der lötfreie, elektrisch und mechanisch dauerhafte Verbindungen in durchkontaktierten Bohrungen von Leiterplatten hergestellt werden siehe z.B. EP-A-0 140 615 und US-A-4 759 721. Im allgemeinen wird die Einpreß-Befestigung zum Anschluß jeweils eines Bauelementes oder eines Anschlußstieles in jeweils einer Leiterplattenbohrung angewandt, wobei die Anschlußstiele der Bauelemente häufig eine rechteckige Querschnitts-Grundform aufweisen und in vielfältigster Art und Weise mit Einpreßzonen von unterschiedlichster Querschnittsform ausgebildet sind.

Aus verschiedenen Gründen entstehen bei Anordnungen von Bauteilen oder Bauelementen auf Leiterplatten jedoch sehr beengte Raumverhältnisse. So werden z.B. durch den allgemeinen Trend zur Miniaturisierung per Flächeneinheit immer mehr Anschlußpunkte auf einer Leiterplatte gebraucht. Insbesondere für hohe Frequenzen werden viele Masseverbindungen benötigt. Diese Vielzahl an Anschlußpunkten erschwert die Leiterplattenentflechtung und zwingt zu mehrlagigen Leiterplatten. Dies ist z.B. beim Anschluß von Masseblechen, die auf gegenüberliegenden Seiten der Leiterplatte stehen, der Fall. Dafür wurden bisher zwei Lochreihen benötigt, wodurch Platz verloren geht und die Schirmwirkung beeinträchtigt werden kann. Eine andere Möglichkeit ist die Nutzung der Anschlußpunkte alternierend von der einen und der anderen Seite der Leiterplatte, wodurch der für die Signaldurchführung zur Nutzung verbleibende Platz beeinträchtigt wird.

Der Erfindung liegt die Aufgabe zugrunde, für die Befestigung von Bauteilen in Leiterplattenbohrungen in Einpreßtechnik eine möglichst raumsparende Nutzung von Anschlußmöglichkeiten zu schaffen.

Diese Aufgabe wird bei einer Einpreß-Befestigung der eingangs genannten Art gemäß der Erfindung durch folgende Merkmale gelöst:
a) zur Befestigung von zwei Bauteilen in einer Leiterplattenbohrung von gegenüberliegenden Seiten der Leiterplatte her sind die Anschlußstiele der beiden Bauteile in einer T-förmigen Grundanordnung in die Leiterplattenbohrung eingepreßt,
b) der den Querbalken der T-förmigen Grundanordnung bildende Anschlußstiel ist zuerst in die Leiterplattenbohrung eingeführt,
c) mindestens ein Anschlußstiel ist elastisch verformbar, so daß die Anschlußstiele der beiden Bauteile im in die Leiterplattenbohrung eingeführten Zustand eine elastische Einpreßzone bilden.

Eine derartige Einpreß-Befestigung ermöglicht den Anschluß zweier Bauteile, z.B. zweier Massebleche, die auf gegenüberliegenden Seiten einer Leiterplatte angeordnet sind, in den gleichen Leiterplattenbohrungen, d.h. die Befestigung von zwei Bauteilen bzw. von zwei Anschlußstielen von zwei Bauteilen kann von gegenüberliegenden Seiten der Leiterplatte her in einer einzigen Leiterplattenbohrung erfolgen. Dadurch werden für derartige Anschlüsse nur halb so viele Leiterplattenbohrungen benötigt und es bleibt mehr Platz für andere Zwecke, z.B. zur Entflechtung oder Signaldurchführung.

Vorteilhafte Ausgestaltungen des Gegenstandes des Anspruchs 1 sind in den Unteransprüchen angegeben.

Die Erfindung wird im folgenden anhand von in der Zeichnung schematisch dargestellten Ausführungsbeispielen näher erläutert. Es zeigen jeweils in einer Querschnittsdarstellung
Fig. 1 die Grundanordnung einer Einpreß-Befestigung für die Anschlußstiele von zwei Bauteilen in einer Leiterplattenbohrung,
Fig. 2 die Einpreß-Befestigung nach Fig. 1 bei in eine Leiterplattenbohrung eingeführtem Zustand,
Fig. 3 und 4 weitere Ausführungsformen einer Einpreß-Befestigung und
Fig. 5 eine Weiterbildung der Ausführungsform nach Fig.4.

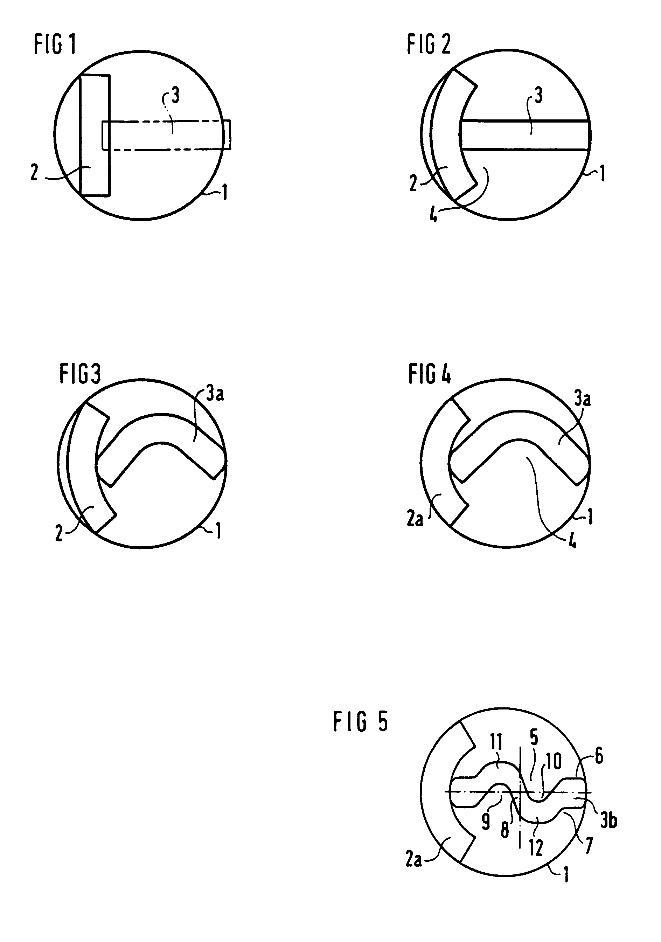

Zur Einpreß-Befestigung von zwei Bauteilen in einer metallisierten Leiterplattenbohrung 1 von gegenüberliegenden Seiten der Leiterplatte her ist jedes hier nicht näher dargestellte, z.B. von einem oberen oder unteren Masse- oder Abschirmblech einer geschirmten Federleiste eines Steckverbinders gebildete Bauteil mit einem Anschlußstiel 2 bzw. 3 von einer im Querschnitt rechteckigen Grundform ausgebildet. Die Anschlußstiele 2 und 3 sind - wie sich aus Fig. 1 für den Anschlußstiel 2 des einen Bauteiles und für den strichpunktiert eingezeichneten Anschlußstiel 3 des anderen Bauteiles ergibt - in einer T-förmigen Grundanordnung senkrecht zueinander gerichtet, wobei von einer Seite der Leiterplatte her der den Querbalken bildende Anschlußstiel 2 des einen Bauteiles als erster Anschlußstiel und mit Spiel in die Leiterplattenbohrung 1 eingeführt wird. Nach seiner Einführung in die Leiterplattenbohrung wird der QuerbalkenAnschlußstiel 2 in Längsrichtung arretiert. Dazu kann der Querbalken-Anschlußstiel 2 mit einem Rastelement, z.B. in Form eines Schnapphakens, ausgebildet sein, der über den Rand der Leiterplattenbohrung 1 einrastet. Stattdessen kann der Querbalken-Anschlußstiel 2 aber auch mittels eines Stützwerkzeuges gehalten werden. Der dritte Schritt besteht darin, daß nun der den Längsbalken bildende Anschlußstiel 3 des anderen Bauteiles von der anderen Seite der Leiterplatte her in die Leiterplattenbohrung 1 eingepreßt wird. Dabei ist mindestens ein Anschlußstiel 2 oder 3 elastisch verformbar und der andere Anschlußstiel starr ausgebildet, oder es sind beide Anschlußstiele elastisch verformbar, so daß die Anschlußstiele 2,3 der beiden Bauteile im in die Leiterplattenbohrung 1 eingepreßten Zustand eine elastische Einpreßzone 4 bilden, in der sich die beiden Anschlüsse gegenseitig an die Bohrungswandung drücken und somit für eine elektrisch niederohmige und mechanisch robuste Verbindung sorgen.

Bei der Ausführungsform nach Fig. 2, welche die Einpreß-Befestigung nach Fig. 1 im in die Leiterplattenbohrung 1 eingepreßten Zustand zeigt, ist der Querbalken-Anschlußstiel 2 des einen Bauteiles elastisch verformbar und der Längsbalken-Anschlußstiel 3 des anderen Bauteiles starr,so daß der Querbalken-Anschlußstiel 2 beim Einpressen des Längsbalken-Anschlußstieles 3 federnd zur Bohrungswandung hin durchgewölbt wird.

Bei der Ausführungsform nach Fig. 3 ist sowohl der wiederum zuerst in die Leiterplattenbohrung 1 eingeführte Querbalken-Anschlußstiel 2 des einen Bauteiles als auch der Längsbalken-Anschlußstiel 3a des anderen Bauteiles elastisch verformbar, z.B. indem letzterer zumindest einen elastischen Bereich hat, der - wie in Fig.3 dargestellt - eine etwa rechtwinklige Durchbiegung des Längsbalken-Anschlußstieles 3a ermöglicht.

Bei der Ausführungsform nach Fig. 4 schließlich ist der ebenfalls zuerst in die Leiterlattenbohrung 1 eingeführte Querbalken-Anschlußstiel 2a des einen Bauteiles vor dem Einführen an die Wandung der Leiterplattenbohrung angepaßt vorgeformt, so daß er satt an der Wandung der Leiterplattenbohrung anliegt. Bei dieser Einpreß-Befestigung ist nur der Längsbalken-Anschlußstiel 3a des anderen Bauteiles elastisch verformbar, so daß die Elastizität der Einpreßzone 4 ausschließlich von dem Längsbalken-Anschlußstiel 3a erzeugt wird.

Die elastische Verformbarkeit des Längsbalken-Anschlußstieles kann - wie Fig.5 in einer Weiterbildung der Ausführungsform nach Fig. 4 zeigt - auch dadurch erzielt werden, daß der Längsbalken-Anschlußstiel 3b selbst noch eine elastische Einpreßzone 5 mit einem symmetrischen, S- oder Z-förmigen Querschnittsprofil aufweist. Die Einpreßzone 5 ist dadurch gebildet, daß in den Längsbalken-Anschlußstiel 3b an zwei einander gegenüberliegenden Seiten 6,7 gegen die Mittelachse 8 seitlich versetzte Rinnen 9,10 so eingeprägt sind, daß über die ursprüngliche Materialdicke der rechteckigen Grundform des Längsbalken-Anschlußstieles 3b hinaus Ausbuchtungen 11,12 hervortreten. Die Einpreßzone 5 besitzt eine hohe Elastizität und kann z.B. auch bei einem Längsbalken-Anschlußstiel in Verbindung mit einem Querbalken-Anschlußstiel 2 nach Fig. 2 oder 3 vorgesehen werden.

## Patentansprüche

1. Einpreß-Befestigung für mit einem Anschlußstiel ausgebildete Bauteile in Leiterplattenbohrungen, wobei die Anschlußstiele der Bauteile eine im Querschnitt rechteckige Grundform aufweisen, insbesondere für Steckverbinder oder Teile davon,
**gekennzeichnet** durch folgende Merkmale:
a) zur Befestigung von zwei Bauteilen in einer Leiterplattenbohrung (1) von gegenüberliegenden Seiten der Leiterplatte her sind die Anschlußstiele (2,3) der beiden Bauteile in einer T-förmigen Grundanordnung in die Leiterplattenbohrung (1) eingepreßt,
b) der den Querbalken der T-förmigen Grundanordnung bildende Anschlußstiel (2) ist zuerst in die Leiterplattenbohrung (1) eingeführt,
c) mindestens ein Anschlußstiel (2,3) ist elastisch verformbar, so daß die Anschlußstiele der beiden Bauteile im in die Leiterplattenbohrung (1) eingeführten Zustand eine elastische Einpreßzone (4) bilden.

2. Einpreß-Befestigung nach Anspruch 1,
**dadurch gekennzeichnet**, daß der den Querbalken bildende Anschlußstiel (2) elastisch verformbar und der den Längsbalken bildende Anschlußstiel (3) starr ist.

3. Einpreß-Befestigung nach Anspruch 1,
**dadurch gekennzeichnet**, daß der den Querbalken bildende Anschlußstiel (2a) an die Wandung der Leiterplattenbohrung (1) angepaßt vorgeformt und der den Längsbalken bildende Anschlußstiel (3a) elastisch verformbar ist.

4. Einpreß-Befestigung nach Anspruch 3,
**dadurch gekennzeichnet**, daß der den Querbalken bildende Anschlußstiel (2,2a) nach seiner Einführung in die Leiterplattenbohrung (1) in Längsrichtung arretiert ist.

5. Einpreß-Befestigung nach Anspruch 4,
**dadurch gekennzeichnet**, daß der den Querbalken bildende Anschlußstiel (2,2a) mit mindestens einem über dem Rand der Leiterplattenbohrung (1) einrastenden Rastelement ausgebildet ist.

6. Einpreß-Befestigung nach einem der Ansprüche 3 bis 5,
**dadurch gekennzeichnet**, daß der den Längsbalken bildende Anschlußstiel (3b) mit einer an zwei einander gegenüberliegenden Seiten (6,7) in die rechteckige Querschnittsgrundform eingeprägten elastischen Einpreßzone (5) mit einem S- oder Z-förmigen Querschnittsprofil ausgebildet ist.

## Claims

1. Press-in fastening, for components designed with a connecting pin, in printed circuit board holes, the connecting pins of the components having a basic shape of rectangular cross section, in particular for plug-in connectors or parts thereof, characterized by the following features:
a) in order to fasten two components in a printed circuit board hole (1) from opposite sides of the printed circuit board, the connecting pins (2, 3) of the two components are pressed into the printed circuit board hole (1) in a T-shaped basic arrangement,
b) the connecting pin (2) forming the transverse bar of the T-shaped basic arrangement is inserted into the printed circuit board hole (1) first,
c) at least one connecting pin (2, 3) is elastically deformable, so that the connecting pins of the two components form an elastic press-in zone (4) when inserted into the printed circuit board hole (1).

2. Press-in fastening according to Claim 1, characterized in that the connecting pin (2) forming the transverse bar is elastically deformable, and the connecting pin (3) forming the longitudinal bar is rigid.

3. Press-in fastening according to Claim 1, characterized in that the connecting pin (2a) forming the transverse bar is pre-shaped in a manner matching the wall of the printed circuit board hole (1), and the connecting pin (3a) forming the longitudinal bar is elastically deformable.

4. Press-in fastening according to Claim 3, characterized in that, following its insertion into the printed circuit board hole (1), the connecting pin (2, 2a) forming the transverse bar is locked in the longitudinal direction.

5. Press-in fastening according to Claim 4, characterized in that the connecting pin (2, 2a) forming the transverse bar is designed with at least one latching element that latches over the edge of the printed circuit board hole (1).

6. Press-in fastening according to one of Claims 3 to 5, characterized in that the connecting pin (3b) forming the longitudinal bar is designed with an elastic press-in zone (5) that is impressed on two opposite sides (6, 7) into the basic shape of rectangular cross section and has an S-shaped or Z-shaped cross-sectional profile.

## Revendications

1. Fixation en force pour composants formés avec une tige de raccordement dans les trous d'un circuit imprimé, lesdites tiges de raccordement des composants présentant une section de base de forme rectangulaire, en particulier pour des connecteurs à fiches ou pour des parties de ces derniers,
caractérisée par les caractéristiques suivantes :
a) pour la fixation de deux composants dans un trou de circuit imprimé (1) à partir de faces opposées du circuit imprimé, les tiges de raccordement (2, 3) des deux composants sont forcées dans le trou du circuit imprimé (1) dans une disposition de base en forme de T,
b) la tige de raccordement (2) formant la barre transversale de la disposition de base en forme de T est introduite en premier dans le trou du circuit imprimé (1),
c) au moins une tige de raccordement (2, 3) est déformable élastiquement, de telle sorte que les tiges de raccordement des deux composants forment dans l'état introduit dans le trou du circuit imprimé (1) une zone d'insertion élastique (4).

2. Fixation en force selon la revendication 1,
caractérisée en ce que la tige de raccordement (2) formant la barre transversale est déformable élastiquement et la tige de raccordement (3) formant la barre longitudinale est rigide.

3. Fixation en force selon la revendication 1,
caractérisée en ce que la tige de raccordement (2a) formant la barre transversale est préformée de façon ajustée à la paroi du trou du circuit imprimé (1) et la tige de raccordement (3a) formant la barre longitudinale est déformable élastiquement.

4. Fixation en force selon la revendication 3,
caractérisée en ce que la tige de raccordement (2, 2a) formant la barre transversale est bloquée dans le sens longitudinal après son introduction dans le trou du circuit imprimé (1).

5. Fixation en force selon la revendication 4,
caractérisée en ce que la tige de raccordement (2, 2a) formant la barre transversale est formée avec au moins un cran d'arrêt s'enclenchant au dessus du bord du trou du circuit imprimé (1).

6. Fixation en force selon l'une des revendications 3 à 5,
caractérisée en ce que la tige de raccordement (3b) formant la barre longitudinale est formée avec une zone d'insertion (5) élastique imprimée sur deux faces opposées l'une de l'autre (6, 7) dans la section de base de forme rectangulaire, ladite zone ayant un profil en coupe en forme de S ou de Z.
